# EUROPEAN PATENT SPECIFICATION

(11) **EP 4 468 327 B1**
(45) Date of publication and mention of the grant of the patent: **01.07.2026**
(21) Application number: 23174454.1
(22) Date of filing: 22.05.2023
(51) Int. Cl.: H10P 72/00

(54) **WARPAGE INSPECTION APPARATUS AND WARPAGE INSPECTION METHOD**
VORRICHTUNG ZUR INSPEKTION VON VERWERFUNGEN UND VERFAHREN ZUR INSPEKTION VON VERWERFUNGEN
APPAREIL D'INSPECTION DE GAUCHISSEMENT ET PROCÉDÉ D'INSPECTION DE GAUCHISSEMENT

(43) Date of publication of application: 27.11.2024
(73) Proprietor: ERS electronic GmbH, 82110 Germering (DE)
(72) Inventor: RACHO SANCHEZ, Debbie Claire, 82110 Germering (DE)
(74) Representative: Isarpatent

(56) References cited:
- KR-A- 20110 026 974
- US-A1- 2011 265 578
- US-A1- 2023 110 011

## Description

The present invention relates to a warpage inspection apparatus and to a warpage inspection method for a disc-shaped workpiece, in particular a semiconductor or mold wafer.

Fan-out wafer-level packaging (FOWLP) has emerged as an advanced packaging technology for semiconductor devices, especially for mobile and loT applications.

The Fanout Wafer Level Packaging (FOWLP) technology has gained widespread attention due to its numerous advantages, including improved thermal and electrical performance, support for multi-die configurations, and high-density routing. Many packaging solutions providers have adopted this technology to facilitate the development of high-performance devices.

However, the technology also has two well-known issues: die shift and warpage. Die shift refers to the offset of the die in comparison to its designed position, while
warpage is a deformation of the wafer caused by a mismatch of the coefficient of thermal expansion (CTE) between semiconductor and mold. Warpage can cause significant issues during high volume manufacturing, as it hinders the smooth handling of wafers across different platforms, ranging from flat stages to pin-up positions and transport robots' end-effectors.

To resolve the issue of warpage, a warpage reduction process can be
employed, or the wafer's structure can be altered to achieve a workable magnitude of deformation. However, in selecting the appropriate structure combination, such as thicker semiconductor, thicker overmold, or increased die-to-die pitch, it is crucial to understand how the wafer behaves at different stages. For instance, a thin wafer
may sag in the middle if placed in a wide diameter end-effector, but it may sag on the edge when placed in a stage pin-up position. There are significant differences in warpage profiles observed across different platforms, and these differences are often correlated with the wafer's structure.

Understanding warpage is essential in ensuring the quality and reliability of the packaged device. By monitoring and measuring warpage during the FOWLP process, manufacturers can identify and address issues before they become significant problems. For example, measuring the warpage can help determine the optimal die placement on the substrate, ensuring that the die is not stressed, and the resulting packaged device has the desired properties.

Additionally, understanding the causes and effects of warpage can help in the design of the FOWLP process and machine selection and handling optimization, ensuring that they can withstand the stresses and strains of the process.

Warpage can manifest in several forms, including bow, twist and warp. There are several causes of warpage, including the coefficient of thermal expansion (CTE) mismatch between the substrate and the die, residual stresses, and material properties.

As FOWLP technology continues to be adopted for core and high-end application, optimizing handling capability through warpage characterization becomes imperative.

US 8 599 366 B2 discloses a method and a device for determining a deformation of a disc-shaped workpiece, in particular a semiconductor or mold wafer.

JP 2018 179 680 A discloses an information acquiring means for acquiring information on the surface of an inspection object and control means for determining the surface condition of the inspection object on the basis of the information taken in by the information taking means. A distance measuring unit is used for focusing on the surface of the object to be inspected, wherein the control unit is configured to be able to detect the warpage of the object to be inspected based on the distance measurement result of the distance measuring unit.

JP 2012 193 968 A discloses a warpage inspection apparatus and a warpage inspection method for inspecting warpage occurring in an inspection object formed in a flat shape such as a ceramic substrate.

US 2011/265578 A1 discloses an optical metrology device that determines local stress in a film on a substrate. The metrology device maps the thickness of the substrate prior to processing, determines the surface curvature of the substrate caused by the processing, and maps the thickness of a film on the top surface after of the substrate after processing.

US 2023/110011 A1 discloses a stage apparatus for holding a substrate including a substrate holding unit including a holding surface that holds the substrate, a driving mechanism configured to transfer the substrate to the holding surface, and a control unit configured to decide, based on warpage information, a driving profile of the substrate by the driving mechanism such that the substrate is transferred to the holding surface while the warping of the substrate is corrected.

KR 2011 0026974 A discloses a substrate thermal processing apparatus capable of detecting and checking a warped state of a substrate while a substrate is being transferred to a substrate thermal processing unit for performing a heat treatment process.

It is an object of the present invention to provide an improved warpage inspection apparatus and warpage inspection method, particularly for semiconductor or mold wafers, which can accurately characterize the wafer warpage response for different platforms.

The invention provides a warpage inspection apparatus according to independent claim 1 and a warpage inspection method according to independent claim 16 for a disc-shaped workpiece, in particular a semiconductor or mold wafer.

Advantageously, the present invention provides a contactless metrology tool that employs advanced optical scanning technology to accurately measure wafer deformities in multiple different platforms. It provides a comprehensive and precise analysis of wafer warpage, which is crucial for ensuring the quality of semiconductor devices.

The warpage inspection apparatus according to the present invention uses a optical scanner which preferably has high-resolution and which captures surface data of the wafer at multiple points or locations, enabling it to generate an accurate 2D and/or 3D map of the wafer surface. The system's software algorithms then analyze the collected data to accurately calculate the wafer's warpage profile, including variations in the curvature and thickness of the wafer.

Preferably, the views can be rotated, zoomed in, and manipulated, allowing users to view the warpage profile from different angles and assess its impact on the wafer's performance. Per-ferably, the software can generate reports and graphs that help users interpret the measurement results and make informed decisions. The apparatus is easy to use with a user-friendly interface that allows for quick and efficient measurement setup and execution. The tool's contactless operation also reduces the risk of contamination and damage to the wafer, ensuring that the measurement results are accurate and reliable.

Measuring at different platforms allow the user to forecast and simulate the warpage behavior of the wafer at different handling stages. Preferably, the changes of the different platforms and the measurements thereon are automatically performed without interference of the user. This information can be utilized to adjust on robots, transport method, and hardware design thus eliminating wafer excursion.

Preferred embodiments are listed in the respective dependent claims.

According to a preferred embodiment the support frame includes a lower body part to be placed on ground and an upper plate part which are coupled together by an adjustable leveling means for leveling the xy-plane. Thus, the measurements can be performed in a levelled xy-plane.

According to another preferred embodiment the warpage inspection apparatus further comprises a measurement controller for controlling the optical sensor means and the moving table and the lift pins in the respective measurement modes.

According to the present invention the vacuum system is connected or connectable to the end effector.

According to another preferred embodiment the end effector includes a first prong and a second prong and multiple pairs of vacuum suction holes are arranged oppositely on different length locations of the first and second prong.

According to another preferred embodiment the vacuum controller is arranged to selectively vacuum each pair of vacuum suction holes in the third measurement mode. Thus, in the third measurement mode various measurements can be performed with chuck mounting by different pairs of vacuum suction holes.

According to another preferred embodiment the warpage inspection apparatus further comprises a temperature control system connected to chuck and a temperature controller for controlling the temperature control system in the first measurement mode. Thus, the first measurement mode can be performed at different temperatures.

According to another preferred embodiment the measurement controller and/or the vacuum controller and/or the temperature controller are arranged in the support frame, particularly the lower body part of the support frame.

According to another preferred embodiment the warpage inspection apparatus further comprises display means controllable by the measurement controller for displaying measurement results of the measurement modes as two and/or three dimensional views. This allows an easier intuitive understanding of the measurement data.

According to another preferred embodiment the warpage inspection apparatus further comprises input means for selecting the measurement modes and measurement mode sequence.

According to another preferred embodiment the input means is arranged to manipulate the views, such that they can be rotated and zoomed allowing the user to view the measured warpage profile of the disc-shaped workpiece from different angles of view. This further con-tibutes to understand the measurement data.

According to another preferred embodiment the chuck includes multiple groups of movable lift pins symmetrically or asymmetrically arranged along different concentric circles on the chuck which are individually controllable to lift the disc-shaped workpiece by the measurement controller in the second measurement mode. Thus, in the second measurement mode different measurements with different groups of lift pins being lifted may be performed.

According to another preferred embodiment the fork-shaped end effector is manually connectable to the moving table by a connector.

According to another preferred embodiment the fork-shaped end effector is connected to the moving table by a movable connector which is arranged to lift the disc-shaped workpiece from the lift pins in order to bring it into the third measurement mode.

According to another preferred embodiment the optical sensor means includes a multi-color confocal camera. This helps to obtain accurate high resolution data.

According to another preferred embodiment the optical sensor means is mounted on a holder which is adjustable in z-direction to adjust the distance to the disc-shaped workpiece in the respective measurement modes.

In the following, preferred embodiments of the present invention are described in conjunction with the accomanying drawings.

In the figures:
- Fig. 1a), b): show schematic views of a warpage inspection apparatus according to a first embodiment of the present invention, namely Fig. 1a) a schematic frontal side view and Fig. 1b) a schematic perspective view;
- Fig. 2a)-c): show partial perspective views of three different wafer platforms to be used in the warpage inspection apparatus according to the embodiments of the present invention, namely Fig. 2a) the chuck as platform wherein the lift pins are sunk in the chuck in the first measurement mode, Fig. 2b) the lift pins as platform wherein the lift pins are extended from the chuck in the second measurement mode, and Fig. 2c) the end effector as platform in the third measurement mode;
- Fig. 3: shows a more detailled top view of the end effector and a connector for connecting the end effector to the moving table to be used in the warpage inspection apparatus according to the first embodiment of the present invention;
- Fig. 4: shows a perspective view of the end effector of Fig. 3 wherein the connector is connected to the moving table;
- Fig. 5: shows a schematic perspective view of a warpage inspection apparatus according to a second embodiment of the present invention;
- Fig. 6a),b): show top views of two different chucks to be used in the warpage inspection apparatus according to the embodiments of the present invention, namely Fig. 6a) a first chuck having an asymmetrical lift pin arrangement and Fig. 6) a second chuck having an symmetrical lift pin arrangement;
- Fig. 7a),b): show perspective views of the end effector and a movable connector for connecting the end effector to the moving table to be used in the warpage inspection apparatus according to a third embodiment of the present invention, namely Fig. 7a) in a retracted position of the end effector and Fig. 7b) in a extended position of the end effector; and
- Fig. 8: shows a flowchart of a warpage inspection method according to a fourth embodiment of the present invention.

In the figures identical reference signs denote identical or functionally equivalent components.

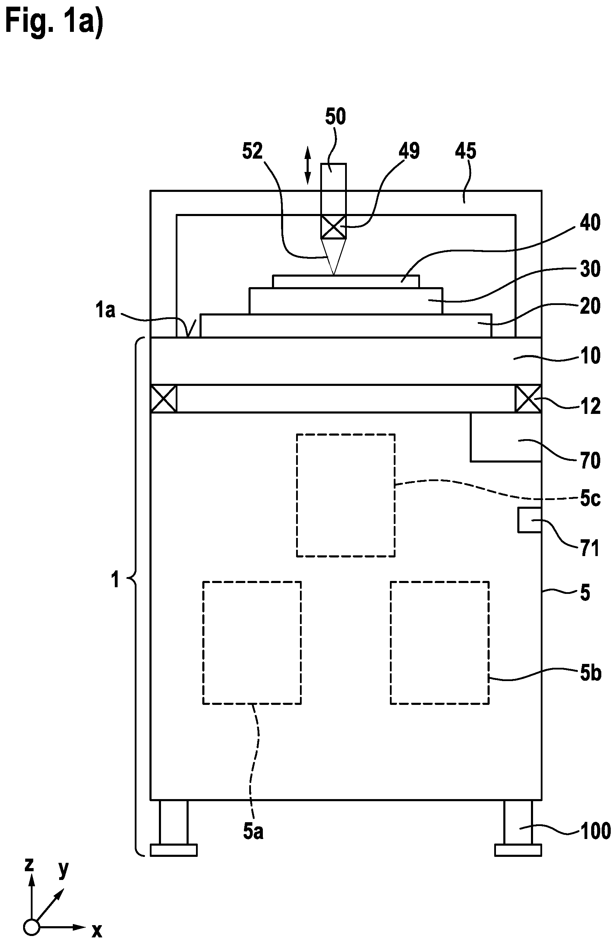

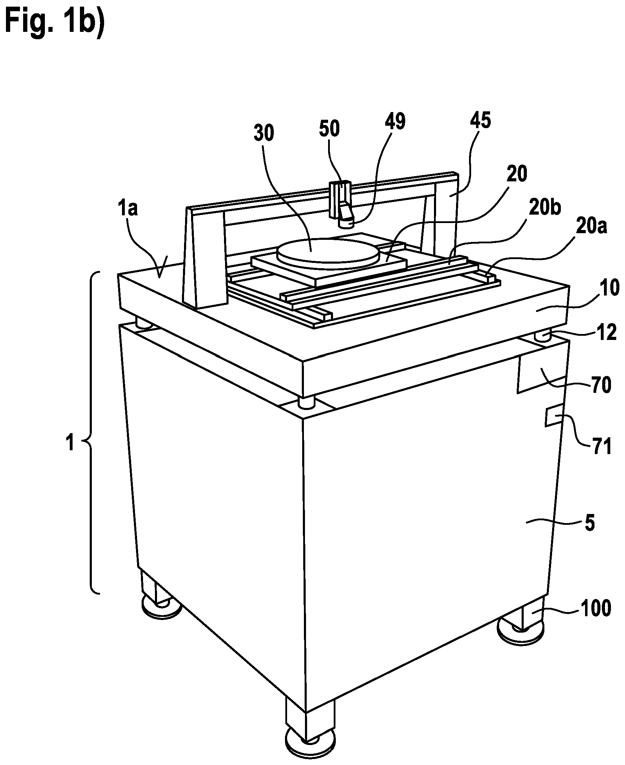

Fig. 1a), b) show schemativ views of a warpage inspection apparatus according to a first embodiment of the present invention, namely Fig. 1a) a schematic frontal side view and Fig. 1b) a schematic perspective view.

The warpage inspection apparatus according to the first embodiment is adapted for a disc-shaped workpiece in form of amold wafer.

It comprises a support frame 1 having an upper support surface 1a which defines an xy-plane. The support frame 1 includes a lower body part 5 having a plurality of legs 100 to be placed on ground and an upper plate part 10 which are coupled together by an adjustable leveling means 12 for leveling the xy-plane. The levelling means 12 can be comprises by rotatable bolts.

A moving table 20 is mounted on the support surface 1a which is movable in the xy-plane, e.g. by means of a cross slide mechanism siliding on orthgonal rails 20a, 20b (see Fig. 1b)).

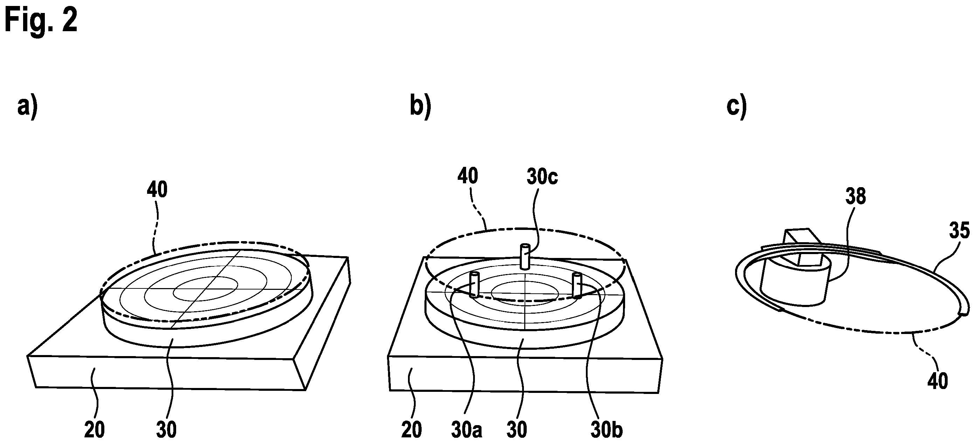

A vacuum chuck 30 is attached to the upper side of the moving table 20 which includes a group of movable lift pins 30a, 30b, 30c (see Fig. 2b)) that are movable between a first position wherein the lift pins 30a, 30b, 30c are sunk in the chuck 30 for mounting the mold wafer 40 on the chuck 30 and a second position wherein the lift pins 30a, 30b, 30c are extended from the chuck 30 for lifting the mold wafer 40 from the chuck 30 in a z-direction which is perpendicular to the xy-plane.

A holding means 45 attached to the support frame 1 which forms a bridge in the first embodiment. An optical sensor means 49 is attached to the bridge-like holding means 45 by means of a holder 50 which is adjustable in z-direction to adjust the distance to the disc-shaped workpiece in the respective measurement modes. The optical sensor means 49 includes a multi-color confocal camera which emits light 52 to the surface of the mold wafer 40 and receives reflected light 52 to measure the surface profile of the mold wafer for determining warpage thereof.

A measurement controller 5a for controlling the optical sensor means 49 and the moving table 20 and the lift pins 30a, 30b, 30c in the respective measurement modes is housed in the lower body part 5 of the support frame 1. For sake of simplicity, the corresponding electrical connections are not shown here.

A vacuum system (not shown) and a vacuum controller 5b for controlling the vacuum system are also housed in the lower body part 5 of the support frame 1. The vacuum system is connected to the chuck 30 and to the vacuum controller 5b for controlling the vacuum system. For sake of simplicity, the corresponding fluid and electrical connections are also not shown here.

A temperature control system (not shown) and a temperature controller 5c for controlling the temperature control system are also housed in the lower body part 5 of the support frame 1. The temperature control system is connected to chuck 30 and the temperature controller 5c for controlling the temperature control system to bring the chuck to a selectable temperatur during the measurement modes. For sake of simplicity, the corresponding fluid and electrical connections are also not shown here.

In the lower body part 5 of the support frame 1 included are also an input means 70, e.g. a keypad, for initiating and selecting the measurement modes, and a interface 71 for outputting the measurement data to an external device, e.g. a personal computer.

Controlled by the measurement controller 5a, the optical sensor means 49 is arranged to measure warpage of the disc-shaped workpiece 40 at a plurality of locations on the the mold wafer in a first measurement mode wherein the lift pins 30a, 30b, 30c of the chuck 30 are in the first position and in a second measurement mode wherein the lift pins 30a, 30b, 30c are in the second position.

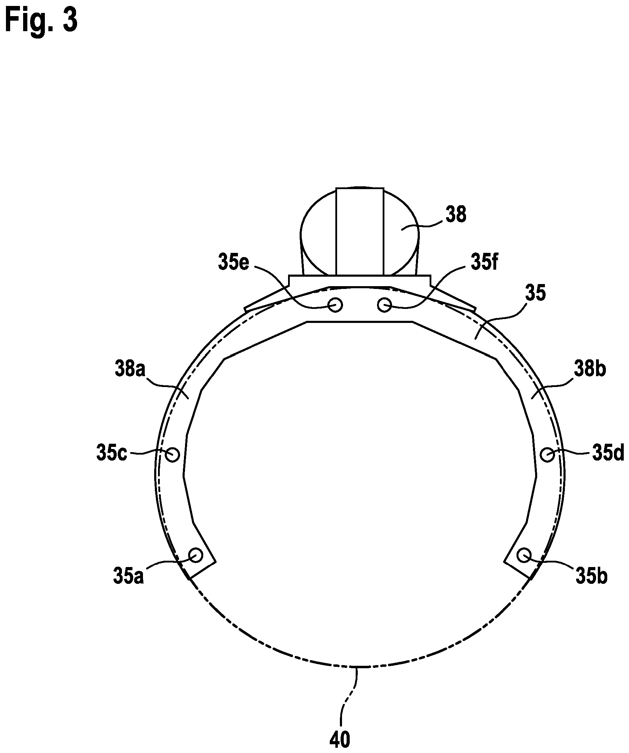

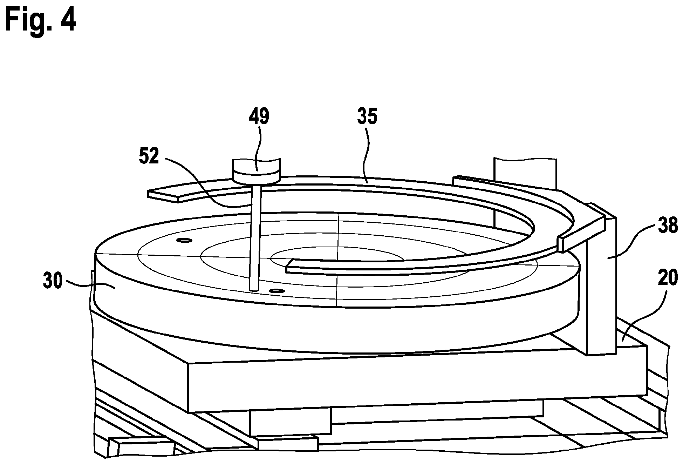

As will be explained further below with reference to Fig. 2c), Fig. 3 and Fig. 4 the warpage inspection apparatus further comprises a fork-shaped end effector 35 connectable to the moving table 20 for mounting the mold wafer 40, and controlled by the measurement controller 5a the optical sensor means 49 is arranged to measure warpage of the mold wafer 40 at a plurality of locations on the the mold wafer 40 in a third measurement mode wherein the mold wafer 40 is mounted on the end effector 35. The vacuum system is connectable to the end effector 35 via fluid lines which are not shown here.

Once the mold wafer 40 is placed on the chuck 30 - either manually or automatically -, the user may enter a desired measurement mode sequence by the input means 70 which will then be automatically controlled by the software of measurement controller 5a. The measurement results will be out put via the interface 70. Then, the next mold wafer 40 may be placed on the chuck 30 and the same measurement mode sequence may be repeated or a new measurement mode sequence ay be input. Should the measurement mode sequence include the third measurement mode in this first embodiment, the user would be prompted to connect the end effector 35 to the moving table 20 manually and to place the moldwafer 40 thereon.

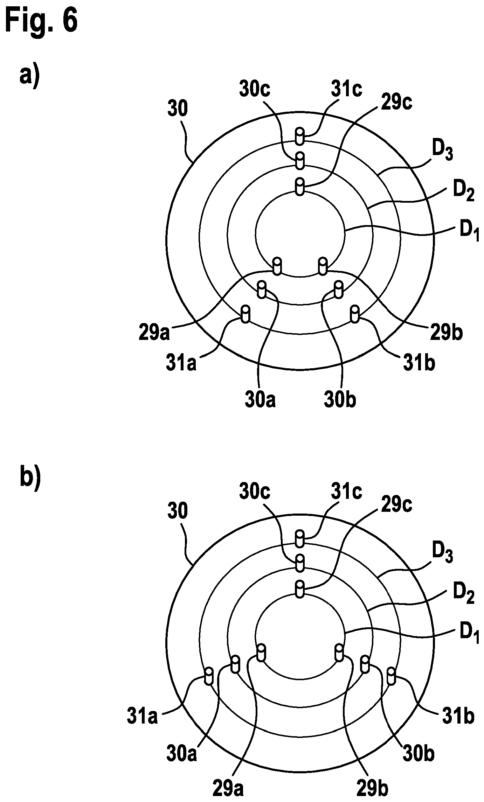

The measurement mode sequence can be selected such that for each measurement mode certain parameters can be determined in advance. For the first measurement mode the temperature and the vacuum state can be selected. For the second measurement mode the the lift pin arrangement (cmp. Fig 6a),b)) can be selected. For the third measurement mode the vacuum suction hole pairs can be selected (cmp. Fig. 3). This provides a very high flexibilty to the user in the definition of the measurement modes and mode sequences.

Fig. 2a)-c) show partial perspective views of three different wafer platforms to be used in the warpage inspection apparatus according to the embodiments of the present invention.

According to Fig. 2a) the chuck 30 serves as platform for the mold wafer 40 (the lift pins are sunk in the chuck 30) in the first measurement mode, according to Fig. 2b) the extended lift pins 30a, 30b, 30c serve as platform for the mold wafer 40 in the second measurement mode, and according to Fig. 2c) the end effector 35 serves as platform for the mold wafer 40 in the third measurement mode.

Fig. 3 shows a more detailled top view of the end effector and a connector for connecting the end effector to the moving table to be used in the warpage inspection apparatus according to the first embodiment of the present invention, and Fig. 4 shows a perspective view of the end effector of Fig. 3 wherein the connector is connected to the moving table.

As shown in Fig. 3, the end effector 35 includes a first prong 38a and a second prong 38b, wherein multiple pairs of vacuum suction holes 35a, 35b and 35c, 35d and 35e, 35f are arranged oppositely on different length locations of the first and second prong 38a, 38b. The vacuum controller 5b is arranged to selectively vacuum each pair of vacuum suction holes 35a, 35b and 35c, 35d and 35e, 35f in the third measurement mode.

As shown in Fig. 4 the connector 38 can be attached to the moving table 20, e.g. by a plug-in mechanism. The vaccum system is connected by corresponding fluid lines provided in the connector 38 and the moving table 20 which are not shown here.

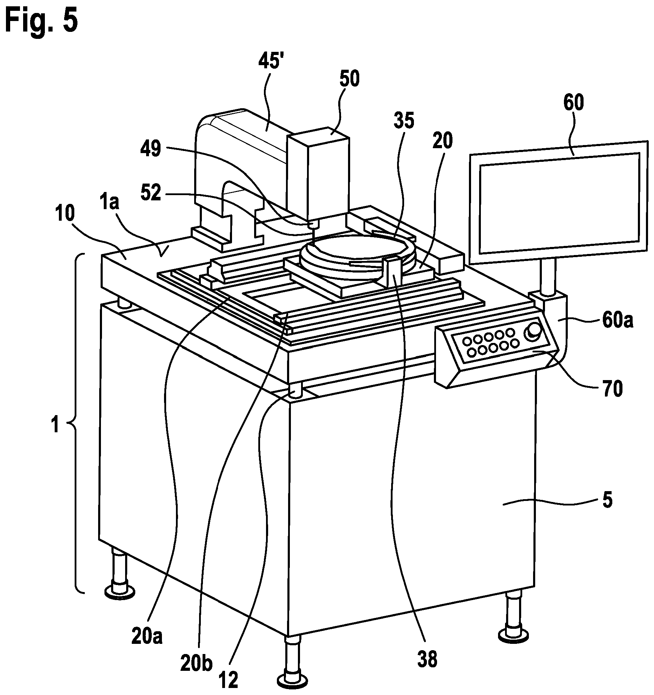

Fig. 5 shows a schematic perspective view of a warpage inspection apparatus according to a second embodiment of the present invention.

The warpage inspection apparatus according to a second embodiment differs from the warpage inspection apparatus according to the first embodiment in that instead or in addition to the interface 71 it comprises display means 60 controllable by the measurement controller 5a for displaying measurement results of the measurement modes as two and/or three dimensional views.

The input means 70 is arranged to manipulate the views, such that they can be rotated and zoomed allowing the user to view the measured warpage profile of the disc-shaped workpiece from different angles of view.

Moreover, the holding means 45' is formed by an angled profile instead as being a bridge as in the first embodiment.

Otherwise, the second embodiment is designed exactly the same as the first embodiment.

Fig. 6a),b) shows top views of two different chucks to be used in the warpage inspection apparatus according to the embodiments of the present invention, namely Fig. 6a) a first chuck having an asymmetrical lift pin arrangement and Fig. 6) a second chuck having an symmetrical lift pin arrangement.

The first chuck 30 of Fig. 6a) includes three groups of movable lift pins 29a, 29b, 29c and 30a, 30b, 30c and 31a, 31b, 31c asymmetrically arranged along three different concentric circles D1, D2, D3 on the chuck 30 which are individually controllable to lift the mold wafer 40 by the measurement controller 5a in the second measurement mode.

The second chuck 30 of Fig. 6b) includes three groups of movable lift pins 29a, 29b, 29c and 30a, 30b, 30c and 31a, 31b, 31c symmetrically arranged along three different concentric circles D1, D2, D3 on the chuck 30 which are individually controllable to lift the mold wafer 40 by the measurement controller 5a in the second measurement mode.

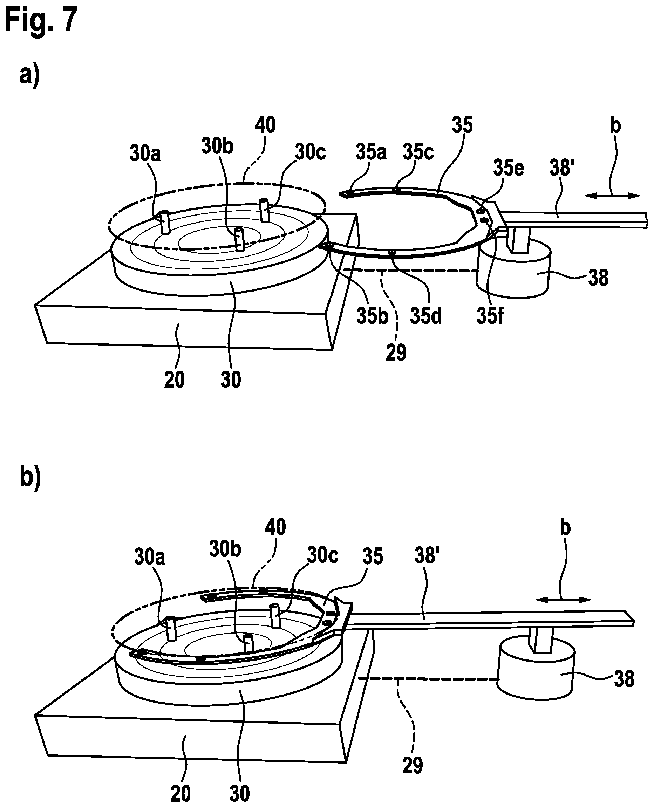

Fig. 7a),b) show perspective views of the end effector and a movable connector for connecting the end effector to the moving table to be used in the warpage inspection apparatus according to a third embodiment of the present invention, namely Fig. 7a) in a retracted position of the end effector and Fig. 7b) in a extended position of the end effector.

The warpage inspection apparatus according to a third embodiment differs from the warpage inspection apparatus according to the first embodiment in that
the fork-shaped end effector 35 is connected to the moving table 20 by a movable connector 38' which is arranged to lift the disc-shaped workpiece from the lift pins 30a, 30b, 30c in order to bring it automatically into the third measurement mode.

By means of the connector 38' the end effector 35 can be moved back and forth along direction b. According to Fig. 7a) the end effector 35 is retracted and the mold wafer 40 rests on the lift pins 30a, 30b, 30c which are in the second position for the second measurement mode. According to Fig. 7b) the end effector 35 is extended under the mold wafer 40 which still rests on the lift pins 30a, 30b, 30c. When the lift pins 30a, 30, 30c are then sunk in the chuck 30, the mold wafer 40 rests on the end effector 35 and is prepared for the third measurement mode.

As indicated by the broken line 29, the connector 38' is either directly or indirectly coupled to the moving table 20 such that the mold wafer 40 resting on the end effector 35 may be brought into the plurality of measurement locations under the optical sensor means 49.

Otherwise, the third embodiment is designed exactly the same as the first embodiment.

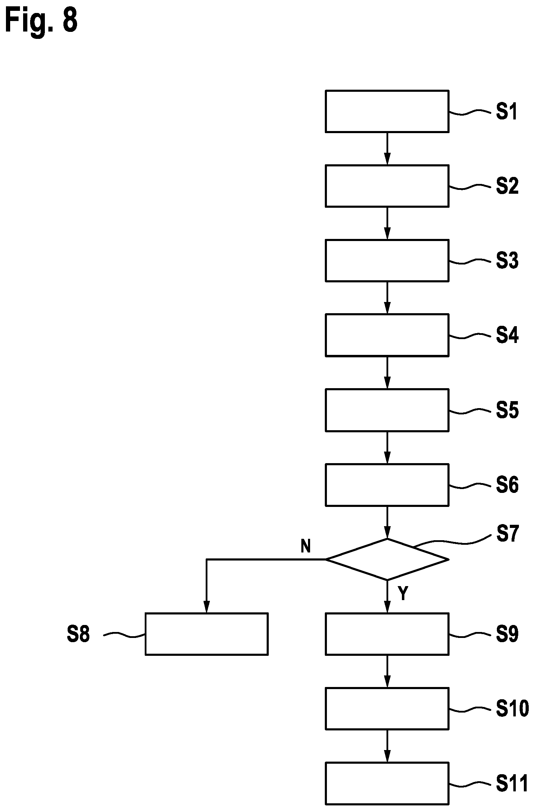

Fig. 8 shows a flowchart of a warpage inspection method according to a fourth embodiment of the present invention.

In step S1 the mold wafer is placed on the chuck 30 - either manually or automatically - of the warpage inspection apparatus any of the preceeding embodiments.

In step S2 the user may enter a desired measurement mode sequence and parameters therof by the input means 70 which will then be automatically controlled by the software of measurement controller 5a, as already explained above.

As example, if the first measurement mode without vacuum and the second measurement mode with lift pins 30a, 30b, 30c have been selected, the user may start the measurement mode sequence in step S3.

In step S4 measuring warpage of the mold wafer 40 at a plurality of locations on the the mold wafer in the first measurement mode wherein the lift pins 30 are in the first position is performed without vacuum.

In step S5, the process automatically enters the second measurement mode by lifting the lift pins 30a, 30b, 30c.

In step S6 measuring warpage of the mold wafer 40 at a plurality of locations on the the mold wafer 40 in the second measurement mode wherein the lift pins 30a, 30b, 30c are in the second position is performed.

In step S7 the user may finish the process or add another measurement mode by the input means 70. If no further measurement mode is selected, the process ends in step S8.

If another measurement mode is selected, e.g. the third measurement mode, in step S9 the effector 35 is connected to the moving table 20 and the mold wafer 40 put theron either manually or by a movable connector 38' which is arranged to lift the mold wafer 40 from the lift pins 30a, 30b, 30c in order to bring it into the third measurement mode.

In step S10 measuring warpage of the mold wafer 40 at a plurality of locations on the the mold wafer 40 in the third measurement mode wherein the mold wafer 40 is mounted on the end effector 35 is performed.

Then, the process ends in step S11.

Although the invention has been described with reference to particular embodiments, it is not limited thereto. Various modifications are possible within the scope of the invention as defined in the appended claims.

Particularly, the warpage inspection apparatus and method ay not only be applied to mold wafers, but also to semiconductor wafers and most generally to any disc-shaped workpiece where warpage has to be measured.

## Claims

1. Warpage inspection apparatus for a disc-shaped workpiece, in particular a semiconductor or mold wafer, comprising:
a support frame (1; 5, 10) having an upper support surface (1a) which defines an xy-plane;
a moving table (20) mounted on the support surface (1a) which is movable in the xy-plane;
a chuck (30) attached to the moving table (20);
wherein the chuck (30) includes a group of movable lift pins (30a, 30b, 30c) which are movable between a first position wherein the lift pins (30a, 30b, 30c) are sunk in the chuck (30) for mounting the disc-shaped workpiece (40) on the chuck (30) and a second position wherein the lift pins (30a, 30b, 30c) are extended from the chuck (30) for lifting the disc-shaped workpiece (40) from the chuck (30) in a z-direction which is perpendicular to the xy-plane;
a holding means (45; 45') attached to the support frame (1; 5, 10);
an optical sensor means (49) attached to the holding means (45) arranged to measure warpage of the disc-shaped workpiece (40) at a plurality of locations on the disc-shaped workpiece (40) in a first measurement mode wherein the lift pins (30a, 30b, 30c) are in the first position and in a second measurement mode wherein the lift pins (30a, 30b, 30c) are in the second position;
a fork-shaped end effector (35) connected or connectable to the moving table (20) for mounting the disc-shaped workpiece (40), wherein the optical sensor means (49) is arranged to measure warpage of the disc-shaped workpiece (40) at a plurality of locations on the disc-shaped workpiece (40) in a third measurement mode wherein the disc-shaped workpiece (40) is mounted on the end effector (35); and
a vacuum system connected to the chuck (30) and a vacuum controller (5b) for controlling the vacuum system in the first measurement mode, wherein the vacuum system is connected or connectable to the end effector (35).

2. Warpage inspection apparatus according to claim 1, wherein the support frame (1; 5, 10) includes a lower body part (5) to be placed on ground and an upper plate part (10) which are coupled together by an adjustable leveling means (12) for leveling the xy-plane.

3. Warpage inspection apparatus according to one of the preceeding claims, further comprising a measurement controller (5a) for controlling the optical sensor means (49) and the moving table (20) and the lift pins (30a, 30b, 30c) in the respective measurement modes.

4. Warpage inspection apparatus according to claim 1, wherein the end effector (35) includes a first prong (38a) and a second prong (38b) and wherein multiple pairs of vacuum suction holes (35a, 35b; 35c, 35d; 35e, 35f) are arranged oppositely on different length locations of the first and second prong (38a, 38b).

5. Warpage inspection apparatus according to claim 4, wherein the vacuum controller (5b) is arranged to selectively vacuum each pair of vacuum suction holes (35a, 35b; 35c, 35d; 35e, 35f) in the third measurement mode.

6. Warpage inspection apparatus according to one of the preceeding claims, further comprising a temperature control system connected to the chuck (30) and a temperature controller (5c) for controlling the temperature control system in the first measurement mode.

7. Warpage inspection apparatus according to one of the preceeding claims, wherein the measurement controller (5a) and/or the vacuum controller (5b) and/or the temperature controller (5c) are arranged in the support frame (1; 5, 10), particularly the lower body part (5) of the support frame (1; 5, 10).

8. Warpage inspection apparatus according to one of the preceeding claims, further comprising display means (60) controllable by the measurement controller (5a) for displaying measurement results of the measurement modes as two and/or three dimensional views.

9. Warpage inspection apparatus according to one of the preceeding claims, further comprising input means (70) for selecting the measurement modes and measurement mode sequence.

10. Warpage inspection apparatus according to claim 9, wherein the input means (70) is arranged to manipulate the views, such that they can be rotated and zoomed allowing the user to view the measured warpage profile of the disc-shaped workpiece from different angles of view.

11. Warpage inspection apparatus according to claim 3, wherein the chuck (30) includes multiple groups of movable lift pins (29a, 29b, 29c; 30a, 30b, 30c; 31a, 31b, 31c) symmetrically or asymmetrically arranged along different concentric circles (D1, D2, D3) on the chuck (30) which are individually controllable to lift the disc-shaped workpiece by the measurement controller in the second measurement mode.

12. Warpage inspection apparatus according to claim 1, wherein the fork-shaped end effector (35) is manually connectable to the moving table (20) by a connector (38).

13. Warpage inspection apparatus according to claim 1, wherein the fork-shaped end effector (35) is connected to the moving table (20) by a movable connector (38') which is arranged to lift the disc-shaped workpiece from the lift pins (30a, 30b, 30c) in order to bring it into the third measurement mode.

14. Warpage inspection apparatus according to one of the preceeding claims, wherein the optical sensor means (49) includes a multi-color confocal camera.

15. Warpage inspection apparatus according to claim 14, wherein the optical sensor means (49) is mounted on a holder (50) which is adjustable in z-direction to adjust the distance to the disc-shaped workpiece in the respective measurement modes.

16. Warpage inspection method for a disc-shaped workpiece using a warpage inspection apparatus according to one of the preceeding claims, comprising the steps of:
measuring warpage of the disc-shaped workpiece (40) at a plurality of locations on the disc-shaped workpiece (40) in the first measurement mode wherein the lift pins (30a, 30b, 30c) are in the first position;
automatically entering the second measurement mode;
measuring warpage of the disc-shaped workpiece (40) at a plurality of locations on the disc-shaped workpiece (40) and in a second measurement mode wherein the lift pins (30a, 30b, 30c) are in the second position;

17. Warpage inspection method according to claim 16, further comprising the steps of automatically or manually entering the third measurement mode and measuring warpage of the disc-shaped workpiece (40) at the plurality of locations on the disc-shaped workpiece (40) in the third measurement mode wherein the disc-shaped workpiece (40) is mounted on the end effector (35).

## Patentansprüche

1. Verwölbungsinspektionsvorrichtung für ein scheibenförmiges Werkstück, insbesondere einen Halbleiter- oder Formwafer, umfassend:
einen Stützrahmen (1; 5, 10), der eine obere Stützfläche (1a) aufweist, die eine xy-Ebene definiert;
einen Positioniertisch (20), der auf der Stützfläche (1a) montiert ist und der in der xy-Ebene beweglich ist;
eine Aufspannvorrichtung (30), die an dem Positioniertisch (20) angebracht ist;
wobei die Aufspannvorrichtung (30) eine Gruppe beweglicher Hebestifte (30a, 30b, 30c) aufweist, die beweglich sind zwischen einer ersten Position, in der die Hebestifte (30a, 30b, 30c) in der Aufspannvorrichtung (30) versenkt sind, um das scheibenförmige Werkstück (40) in der Aufspannvorrichtung (30) zu montieren, und einer zweiten Position, in der die Hebestifte (30a, 30b, 30c) von der Aufspannvorrichtung (30) ausgefahren sind, um das scheibenförmige Werkstück (40) in einer z-Richtung, die senkrecht zu der xy-Ebene verläuft, aus der Aufspannvorrichtung (30) herauszuheben;
ein Haltemittel (45; 45'), das an dem Stützrahmen (1; 5, 10) angebracht ist;
ein optisches Sensormittel (49), das an dem Haltemittel (45) angebracht ist und dafür ausgelegt ist, ein Verwölben des scheibenförmigen Werkstücks (40) an mehreren Stellen auf dem scheibenförmigen Werkstück (40) in einem ersten Messmodus, in dem sich die Hebestifte (30a, 30b, 30c) in der ersten Position befinden, und in einem zweiten Messmodus, in dem sich die Hebestifte (30a, 30b, 30c) in der zweiten Position befinden, zu messen;
einen gabelförmigen Endeffektor (35), der mit dem Positioniertisch (20) verbunden oder verbindbar ist, zum Montieren des scheibenförmigen Werkstücks (40), wobei das optische Sensormittel (49) dafür ausgelegt ist, ein Verwölben des scheibenförmigen Werkstücks (40) an mehreren Stellen auf dem scheibenförmigen Werkstück (40) in einem dritten Messmodus zu messen, in dem das scheibenförmige Werkstück (40) auf dem Endeffektor (35) montiert ist; und
ein Vakuumsystem, das mit der Aufspannvorrichtung (30) verbunden ist, und eine Vakuumsteuerung (5b) zum Steuern des Vakuumsystems in dem ersten Messmodus, wobei das Vakuumsystem mit dem Endeffektor (35) verbunden oder verbindbar ist.

2. Verwölbungsinspektionsvorrichtung nach Anspruch 1, wobei der Stützrahmen (1; 5, 10) einen unteren Korpusteil (5) aufweist, der auf einem Boden zu platzieren ist, und einen oberen Plattenteil (10) aufweist, die durch ein verstellbares Nivelliermittel (12) zum Nivellieren der xy-Ebene miteinander gekoppelt sind.

3. Verwölbungsinspektionsvorrichtung nach einem der vorangehenden Ansprüche, des Weiteren umfassend eine Messsteuerung (5a) zum Steuern des optischen Sensormittels (49) und des Positioniertisches (20) und der Hebestifte (30a, 30b, 30c) in den jeweiligen Messmodi.

4. Verwölbungsinspektionsvorrichtung nach Anspruch 1, wobei der Endeffektor (35) einen ersten Arm (38a) und einen zweiten Arm (38b) aufweist, und wobei mehrere Paare von Vakuumsauglöchern (35a, 35b; 35c, 35d; 35e, 35f) gegenüberliegend an verschiedenen Längenpositionen des ersten und des zweiten Arms (38a, 38b) angeordnet sind.

5. Verwölbungsinspektionsvorrichtung nach Anspruch 4, wobei die Vakuumsteuerung (5b) dafür ausgelegt ist, in dem dritten Messmodus an jedes Paar von Vakuumsaugöffnungen (35a, 35b; 35c, 35d; 35e, 35f) selektiv ein Vakuum anzulegen.

6. Verwölbungsinspektionsvorrichtung nach einem der vorangehenden Ansprüche, des Weiteren umfassend ein Temperatursteuerungssystem, das mit der Aufspannvorrichtung (30) verbunden ist, und eine Temperatursteuerung (5c) zum Steuern des Temperatursteuerungssystems in dem ersten Messmodus.

7. Verwölbungsinspektionsvorrichtung nach einem der vorangehenden Ansprüche, wobei die Messsteuerung (5a) und/oder die Vakuumsteuerung (5b) und/oder die Temperatursteuerung (5c) in dem Stützrahmen (1; 5, 10), insbesondere in dem unteren Korpusteil (5) des Stützrahmens (1; 5, 10), angeordnet sind.

8. Verwölbungsinspektionsvorrichtung nach einem der vorangehenden Ansprüche, des Weiteren umfassend ein Anzeigemittel (60), das durch die Messsteuerung (5a) steuerbar ist, zum Anzeigen von Messergebnissen der Messmodi als zwei- und/oder dreidimensionale Ansichten.

9. Verwölbungsinspektionsvorrichtung nach einem der vorangehenden Ansprüche, des Weiteren umfassend ein Eingabemittel (70) zum Auswählen der Messmodi und der Messmodussequenz.

10. Verwölbungsinspektionsvorrichtung nach Anspruch 9, wobei das Eingabemittel (70) dafür eingerichtet ist, die Ansichten so zu manipulieren, dass sie gedreht und gezoomt werden können, was es dem Benutzer erlaubt, das gemessene Verwölbungsprofil des scheibenförmigen Werkstücks aus verschiedenen Blickwinkeln zu betrachten.

11. Verwölbungsinspektionsvorrichtung nach Anspruch 3, wobei die Aufspannvorrichtung (30) mehrere Gruppen beweglicher Hebestifte (29a, 29b, 29c; 30a, 30b, 30c; 31a, 31b, 31c) aufweist, die symmetrisch oder asymmetrisch entlang verschiedener konzentrischer Kreise (D1, D2, D3) auf der Aufspannvorrichtung (30) angeordnet sind und die einzeln steuerbar sind, um das scheibenförmige Werkstück durch die Messsteuerung in dem zweiten Messmodus anzuheben.

12. Verwölbungsinspektionsvorrichtung nach Anspruch 1, wobei der gabelförmige Endeffektor (35) durch einen Verbinder (38) manuell mit dem Positioniertisch (20) verbindbar ist.

13. Verwölbungsinspektionsvorrichtung nach Anspruch 1, wobei der gabelförmige Endeffektor (35) mit dem Positioniertisch (20) durch einen beweglichen Verbinder (38') verbunden ist, der dafür ausgelegt ist, das scheibenförmige Werkstück von den Hebestiften (30a, 30b, 30c) herunterzuheben, um es in den dritten Messmodus zu bringen.

14. Verwölbungsinspektionsvorrichtung nach einem der vorangehenden Ansprüche, wobei das optische Sensormittel (49) eine mehrfarbige konfokale Kamera aufweist.

15. Verwölbungsinspektionsvorrichtung nach Anspruch 14, wobei das optische Sensormittel (49) an einem Halter (50) montiert ist, der in z-Richtung verstellbar ist, um die Distanz zu dem scheibenförmigen Werkstück in den jeweiligen Messmodi zu verstellen.

16. Verwölbungsinspektionsverfahren eines scheibenförmigen Werkstücks unter Verwendung einer Verwölbungsinspektionsvorrichtung nach einem der vorangehenden Ansprüche, umfassend folgende Schritte:
Messen einer Verwölbung des scheibenförmigen Werkstücks (40) an mehreren Stellen auf dem scheibenförmigen Werkstück (40) in dem ersten Messmodus, in dem sich die Hebestifte (30a, 30b, 30c) in der ersten Position befinden;
automatisches Eintreten in den zweiten Messmodus;
Messen einer Verwölbung des scheibenförmigen Werkstücks (40) an mehreren Stellen auf dem scheibenförmigen Werkstück (40) und in einem zweiten Messmodus, in dem sich die Hebestifte (30a, 30b, 30c) in der zweiten Position befinden;

17. Verwölbungsinspektionsverfahren nach Anspruch 16, des Weiteren umfassend die Schritte des automatischen oder manuellen Eintretens in den dritten Messmodus und des Messens der Verwölbung des scheibenförmigen Werkstücks (40) an den mehreren Stellen auf dem scheibenförmigen Werkstück (40) in dem dritten Messmodus, wobei das scheibenförmige Werkstück (40) an dem Endeffektor (35) montiert ist.

## Revendications

1. Appareil d'inspection de gauchissement pour une pièce en forme de disque, en particulier une plaquette semi-conductrice ou une plaquette de moule, comprenant :
un bâti de support (1 ; 5, 10) ayant une surface de support supérieure (1a) qui définit un plan xy ;
un plateau mobile (20) monté sur la surface de support (1a) qui est mobile dans le plan xy ;
un dispositif de serrage (30) fixé au plateau mobile (20) ;
dans lequel le dispositif de serrage (30) comporte un groupe de pions de soulèvement mobiles (30a, 30b, 30c) qui sont mobiles entre une première position dans laquelle les pions de soulèvement (30a, 30b, 30c) sont abaissés dans le dispositif de serrage (30) pour monter la pièce en forme de disque (40) sur le dispositif de serrage 30), et une seconde position dans laquelle les pions de soulèvement (30a, 30b, 30c) sont déployés à partir du dispositif de serrage (30) pour soulever la pièce en forme de disque (40) à partir du dispositif de serrage (30) dans une direction z qui est perpendiculaire au plan xy ;
un moyen de retenue (45 ; 45') fixé au bâti de support (1 ; 5, 10) ;
un moyen de détection optique (49) fixé au moyen de retenue (45) disposé de manière à mesurer un gauchissement de la pièce en forme de disque (40) à une pluralité d'emplacements sur la pièce en forme de disque (40) dans un premier mode de mesure dans lequel les pions de soulèvement (30a, 30b, 30c) sont dans la première position, et dans un deuxième mode de mesure dans lequel les pions de soulèvement (30a, 30b, 30c) sont dans la seconde position ;
un effecteur terminal en forme de fourchette (35) relié ou pouvant être relié au plateau mobile (20) pour monter la pièce en forme de disque (40), dans lequel le moyen de détection optique (49) est disposé de manière à mesurer le gauchissement de la pièce en forme de disque (40) à une pluralité d'emplacements sur la pièce en forme de disque (40) dans un troisième mode de mesure dans lequel la pièce en forme de disque (40) est montée sur l'effecteur terminal (35) ; et
un système de vide relié au dispositif de serrage (30) et une commande de vide (5b) destinée à commander le système de vide dans le premier mode de mesure, dans lequel le système de vide est relié ou peut être relié à l'effecteur terminal (35).

2. Appareil d'inspection de gauchissement selon la revendication 1, dans lequel le bâti de support (1 ; 5, 10) comporte une partie de corps inférieure (5) à placer sur un sol et une partie de plaque supérieure (10) qui sont couplées ensemble par un moyen de mise à niveau réglable (12) pour mettre à niveau le plan xy.

3. Appareil d'inspection de gauchissement selon l'une des revendications précédentes, comprenant en outre une commande de mesure (5a) pour commander le moyen de détection optique (49) et le plateau mobile (20) et les pions de soulèvement (30a, 30b, 30c) dans les modes de mesure respectifs.

4. Appareil d'inspection de gauchissement selon la revendication 1, dans lequel l'effecteur terminal (35) comporte un premier bras (38a) et un second bras (38b) et dans lequel de multiples paires de trous d'aspiration par le vide (35a, 35b ; 35c, 35d ; 35e, 35f) sont disposés de manière opposée sur des emplacements de différente longueur des premiers et seconds bras (38a, 38b).

5. Appareil d'inspection de gauchissement selon la revendication 4, dans lequel la commande de vide (5b) est disposée de manière à mettre sélectivement sous vide chaque paire de trous d'aspiration par le vide (35a, 35b ; 35c, 35d ; 35e, 35f) dans le troisième mode de mesure.

6. Appareil d'inspection de gauchissement selon l'une des revendications précédentes, comprenant en outre un système de commande de température relié au dispositif de serrage (30) et une commande de température (5c) pour commander le système de commande de température dans le premier mode de mesure.

7. Appareil d'inspection de gauchissement selon l'une des revendications précédentes, dans lequel la commande de mesure (5a) et/ou la commande de vide (5b) et/ou la commande de température (5c) sont disposées dans le bâti de support (1 ; 5, 10), en particulier dans la partie de corps inférieure (5) du bâti de support (1 ; 5, 10).

8. Appareil d'inspection de gauchissement selon l'une des revendications précédentes, comprenant en outre un moyen d'affichage (60) apte à être commandé par la commande de mesure (5a) pour afficher des résultats de mesure des modes de mesure sous forme de vues bidimensionnelles et/ou tridimensionnelles.

9. Appareil d'inspection de gauchissement selon l'une des revendications précédentes, comprenant en outre un moyen d'entrée (70) pour sélectionner les modes de mesure et la séquence de modes de mesure.

10. Appareil d'inspection de gauchissement selon la revendication 9, dans lequel le moyen d'entrée (70) est disposé de manière à manipuler les vues, de telle sorte qu'elles peuvent être tournées et zoomées, en permettant à l'utilisateur de visualiser le profil de gauchissement mesuré de la pièce en forme de disque sous différents angles de prise de vue.

11. Appareil d'inspection de gauchissement selon la revendication 3, dans lequel le dispositif de serrage (30) comporte de multiples groupes de pions de soulèvement mobiles (29a, 29b, 29c ; 30a, 30b, 30c ; 31a, 31b, 31c) disposés symétriquement ou asymétriquement le long de différents cercles concentriques (D1, D2, D3) sur le dispositif de serrage (30) aptes à être commandés individuellement pour soulever la pièce en forme de disque par la commande de mesure dans le deuxième mode de mesure.

12. Appareil d'inspection de gauchissement selon la revendication 1, dans lequel l'effecteur terminal en forme de fourchette (35) peut être relié manuellement au plateau mobile (20) par un raccord (38).

13. Appareil d'inspection de gauchissement selon la revendication 1, dans lequel l'effecteur terminal en forme de fourchette (35) est relié au plateau mobile (20) par un connecteur mobile (38') qui est disposé de manière à soulever la pièce en forme de disque à partir des pions de soulèvement (30a, 30b, 30c) afin de l'amener dans le troisième mode de mesure.

14. Appareil d'inspection de gauchissement selon l'une des revendications précédentes, dans lequel le moyen de détection optique (49) comporte une caméra confocale multicolore.

15. Appareil d'inspection de gauchissement selon la revendication 14, dans lequel le moyen de détection optique (49) est monté sur un support (50) qui est réglable dans la direction z pour régler la distance par rapport à la pièce en forme de disque dans les modes de mesure respectifs.

16. Procédé d'inspection de gauchissement pour une pièce en forme de disque utilisant un appareil d'inspection de gauchissement selon l'une des revendications précédentes, comprenant les étapes consistant à :
mesurer un gauchissement de la pièce en forme de disque (40) à une pluralité d'emplacements sur la pièce en forme de disque (40) dans le premier mode de mesure dans lequel les pions de soulèvement (30a, 30b, 30c) sont dans la première position ;
entrer automatiquement dans le deuxième mode de mesure ;
mesurer le gauchissement de la pièce en forme de disque (40) à une pluralité d'emplacements sur la pièce en forme de disque (40) et dans un deuxième mode de mesure dans lequel les pions de soulèvement (30a, 30b, 30c) sont dans la seconde position.

17. Procédé d'inspection de gauchissement selon la revendication 16, comprenant en outre les étapes consistant à entrer automatiquement ou manuellement dans le troisième mode de mesure et à mesurer le gauchissement de la pièce en forme de disque (40) à la pluralité d'emplacements sur la pièce en forme de disque (40) dans le troisième mode de mesure dans lequel la pièce en forme de disque (40) est montée sur l'effecteur terminal (35).
